(19) Europäisches Patentamt
European Patent Office
Office européen des brevets

(11) **EP 1 337 035 B1**

(12) **EUROPEAN PATENT SPECIFICATION**

(45) Date of publication and mention
of the grant of the patent:
**27.07.2005 Bulletin 2005/30**

(51) Int Cl.⁷: **H03D 7/14**, H03G 1/00

(21) Application number: **02425035.9**

(22) Date of filing: **29.01.2002**

(54) **Mixer with exponentially variable gain**

Mischer mit exponentiell variabler Verstärkung

Mélangeur à gain exponentiel variable

(84) Designated Contracting States:
**DE FR GB IT**

(43) Date of publication of application:
**20.08.2003 Bulletin 2003/34**

(73) Proprietor: **STMicroelectronics S.r.l.**
**20041 Agrate Brianza (Milano) (IT)**

(72) Inventors:
• **Filoramo, Pietro**
**96100 Siracusa (IT)**

• **Granata, Angelo**
**96100 Siracusa (IT)**

(74) Representative: **Pellegri, Alberto et al**
**c/o Società Italiana Brevetti S.p.A.**
**Piazza Repubblica, 5**
**21100 Varese (IT)**

(56) References cited:
**US-A- 5 748 027**   **US-A- 5 933 771**

**Description**

The present invention relates to variable gain mixers and more precisely to an exponentially variable gain mixer.

BACKGROUND OF THE INVENTION

A mixer is a circuit that converts the frequency of a signal and is used in modern transceivers of telecommunication networks. Because of the attenuation to which a transmitted signal may undergo along the path from a transmitter to a receiver, it must be possible to increase the gain of the receiver in order to produce a signal of constant magnitude. Similarly, the transmitter must be able to reduce the power of the transmitted signal in order to make the receiver correctly receive other signals of relatively small magnitude.

The two functions of modulation and amplification with variable gain may be carried out by two distinct circuits, commonly called respectively mixer and variable gain amplifier, or may be carried out by a single circuit, commonly called variable gain mixer or VGM. The latter approach is often preferred because of reduced current dissipation, enhanced noise immunity and reduced nonlinear distortion. Moreover input and output signals in a variable gain mixer have different frequencies, and this favours the isolation between input and output. This characteristic is particularly important if the VGM must be capable of strongly attenuate the output signal.

The gain G of the VGM is in general a function of a gain control voltage VG, that is G=G(VG). Very often an exponential variation law is required in transceivers design in order to have a "linear" variation of the gain expressed in dB, $G_{dB} = 20 \cdot Log(G)$. In order to obtain this type of function, the control voltage VG must be generated by a circuit with an appropriate transfer characteristic.

A possible embodiment of the VGM is described in US Patent No. 5,933,771 by S. A. Tiller et al. and depicted in Figure 1.

The differential current signal ($i_{sig}$, -$i_{sig}$) is the input of a modified version of the so-called "Gilbert Cell", constituted by the transistors Q1, Q2, Q3 and Q4, that modulates the frequency by beating it with a differential voltage signal (Vlo⁺, Vlo⁻) generated by an oscillating circuit.

Let us suppose that such a differential voltage signal has a square-waveform so that, during every half-period, only two of the four transistors Q1-Q4 are on. The final result is a multiplication of the input current $i_{sig}$ by +1 during a half-period and by -1 during the successive half-period.

The current regulating transistors Q5 and Q6 are identical and these are driven by the gain control voltage VG and their function is to shunt part of the current of the input signal ($i_{sig}$, -$i_{sig}$) towards the positive supply Vpos, thus causing an attenuation in function of the voltage VG. When the voltage VG assumes its minimum value, the transistors Q5 and Q6 are turned off and all the signal current $i_{sig}$ is modulated at the output ($i_{out+}$, $i_{out-}$). On the contrary, when the voltage VG assumes its maximum value, all the signal current flows in Q5 and Q6 and thus there is not any output current. In general, the attenuation, that is the ratio between the output current signal $i_{out}$ and the input current signal $i_{sig}$, is analytically expressed by the following equation:

$$\frac{i_{out}}{i_{sig}} = \frac{1}{1 + e^{\frac{VG - Vlo}{V_T}}} \qquad (1)$$

wherein $V_T$ is the so-called thermal voltage. As it may be noted, a drawback of this solution is the fact that the attenuation depends, besides from the voltage VG, also from the amplitude of the differential signal Vlo, which, in general, is independent from the voltage VG.

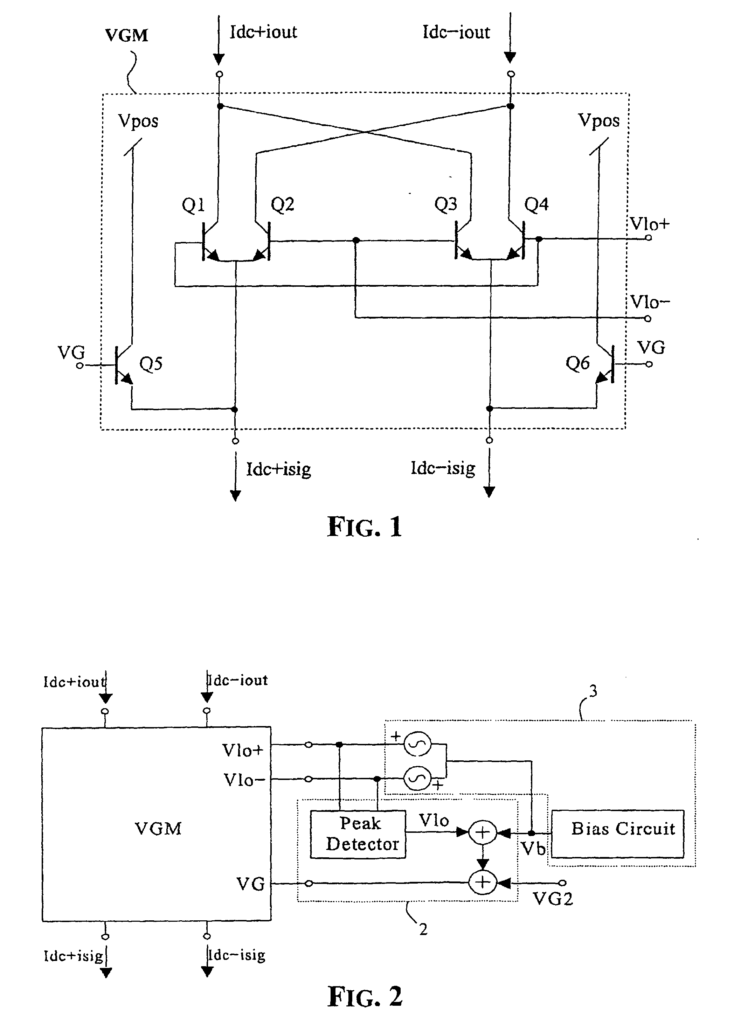

In an attempt to solve this problem, the circuit depicted in Figure 2 has been proposed in [1].

An oscillating circuit 3, comprising a pair of oscillators and a relative bias circuit BIAS_CIRCUIT, generates a differential alternated signal that is input to the variable gain mixer VGM as differential modulation signal (Vlo⁺, Vlo⁻). The peak detector PEAK_DETECTOR included in the correction circuit 2 receives the alternated differential signal and generates the respective peak voltage Vlo.

An externally generated voltage for commanding the variation of the gain VG2, is added to the peak voltage Vlo and to the bias voltage Vb of the oscillators of the circuit 3. In this way, the voltage VG-Vlo, which (see equation (1)) determines the attenuation of the output signal $i_{out}$ in respect to the input signal $i_{sig}$, does not depend anymore from the peak voltage Vlo:

$$VG - Vlo = (VG2 + Vb + Vlo) - Vlo = VG2 + Vb \qquad (2)$$

The drawback of the circuit of Figure 2 consists in the fact that it includes a peak detector that introduces delays and adds noise, and could require nonintegrable elements.

OBJECT AND SUMMARY OF THE INVENTION

It has been found and is the object of the present invention an exponentially variable gain mixer that has a very simple structure and that it is not affected by the above mentioned problems of noise and delay and does not need external components because of the use of a peak detector for its functioning as in the prior art circuits.

More precisely the object of the invention is an exponentially variable gain mixer according to claim 1 comprising a variable gain mixer receiving an input differential signal to be amplified and frequency converted and producing an amplified and frequency converted differential output signal in function of a differential local oscillator signal and of a gain control voltage, at least an oscillating circuit generating an oscillating differential signal, a correction circuit input with an external gain variation command and with the oscillating differential signal for producing the differential local oscillator signal and the gain control voltage.

Differently from comparable known circuits, the modulator of the invention does not require a peak detector because the correction circuit comprises a first amplifier input with the external gain variation command that generates the gain control voltage and a bias voltage as differential output signal, and a second differential amplifier having the bias voltage as a reference, input with the oscillating differential signal that outputs the differential local oscillator signal.

Preferably, the gain of the first amplifier input with the external command varies proportionally with the working temperature, thus making transfer characteristic of the mixer substantially independent from temperature.

According to another embodiment, the modulator of the invention is provided with a compensation circuit coupling the first amplifier to the second amplifier such that the attenuation may vary according to an exponential law with a very high precision.

The invention is precisely defined in the annexed claims.

BRIEF DESCRIPTION OF THE DRAWINGS

The different features and advantages of the invention will appear even more evident through the following detailed description of several embodiments and by referring to the attached drawings, wherein:

**Figure 1** is a classic variable gain mixer;
**Figure 2** depicts a known variable gain mixer using a peak detector;
**Figure 3** depicts a variable gain mixer of the invention not using a peak detector;
**Figure 4** depicts a second embodiment of the mixer of the invention comprising a pre-distortion circuit;
**Figure 5** depicts an auxiliary control circuit that may be used as pre-distortion circuit;
**Figure 6** is a detailed circuit diagram of a mixer of the invention including an auxiliary control circuit.

DESCRIPTION OF SEVERAL EMBODIMENTS OF THE INVENTION

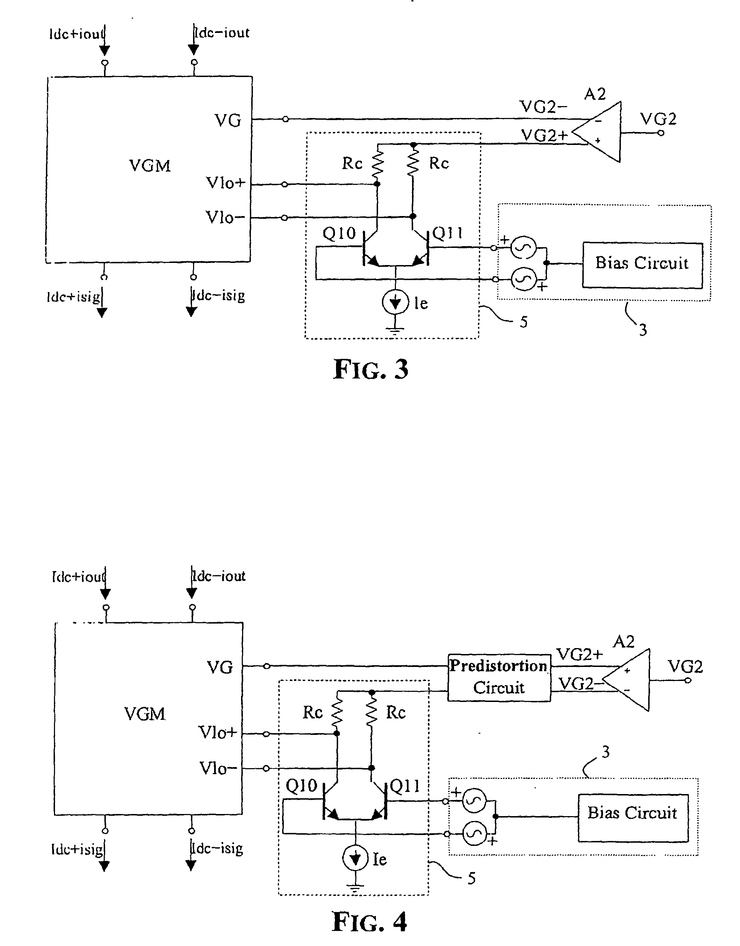

A basic diagram of the mixer of the invention is depicted in Figure 3. The circuit comprises a variable gain mixer VGM, coupled to a correction circuit substantially constituted by a first amplifier A2 and by a second differential amplifier 5. The amplifier A2 is input with the external gain variation command VG2 and generates a control voltage VG2$^-$ and a bias voltage VG2$^+$. The differential amplifier 5, referred to the bias voltage VG2$^+$, is input with the alternated differential signal generated by the oscillating circuit 3 and generates the differential modulation signal (Vlo$^+$, Vlo$^-$).

This approach allows the combination of the differential signal of the local oscillator (Vlo$^+$, Vlo$^-$) with the differential voltages (VG2$^+$, VG2$^-$) in a simple and efficient way, such that the gain of the VGM does not depend from the peak amplitude Vlo of the beat signal. Moreover, this result is obtained without using in the correction circuit 2 any peak detector and/or other circuits that cause delays and/or increase noise.

The gain variation that is produced in the mixer of the invention of Figure 3, as in the prior art modulator of Figure 2, is only ideally an exponential function of the external command VG2. As a matter of fact, the function of the gain variation is only roughly exponential.

Should the mixer of the invention be used in applications that require a highly precise variation of the gain with the external command VG2, according to an exponential law the mixer of the invention of Figure 3 may be provided with appropriate compensation circuits that modify the control of the VGM.

This can be done, for instance, by the use of a pre-distortion circuit that generates the control voltage VG to be input to the VGM by compensatively distorting the differential signal produced by the amplifier A2.

Such a solution is implemented in the mixer of the invention depicted in Figure 4, which comprises a pre-distortion circuit PREDISTORTION_CIRCUIT of the control voltage VG of the VGM.

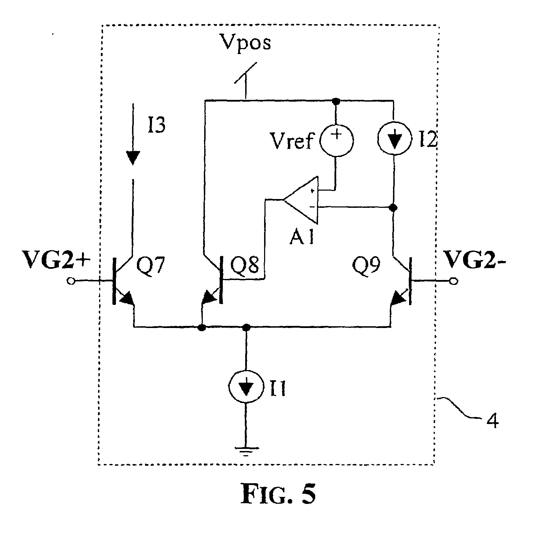

A suitable pre-distortion circuit for obtaining a highly precise exponential gain variation, may include an auxiliary control circuit as the one disclosed in US Patent No. 5,748,027 by R. S. Cargill and depicted in Figure 5.

A differential voltage ($VG2^+$, $VG2^-$) is applied to the bases of the input transistors Q7 and Q9. A constant collector current provided by the current generator I2 flows in the transistor Q9, thus also the base emitter voltage of the transistor Q9 is constant. In these conditions, the collector current of the transistor Q7 may be calculated with the following equation:

$$I3 = K \cdot I2 \cdot e^{\frac{VG2^+ - VG2^-}{V_T}} \qquad (3)$$

where K is the ratio between the emitter areas of transistors Q7 and Q9.

Therefore, the variation of the collector current of transistor Q7 is an exponential function of the voltage ($VG2^+ - VG2^-$) because the current 12 is constant. The current I1-I2-I3 flows through the transistor Q8 and the amplifier A1 prevents saturation of Q9 by regulating the collector voltage of the transistor Q9 to Vpos - Vref.

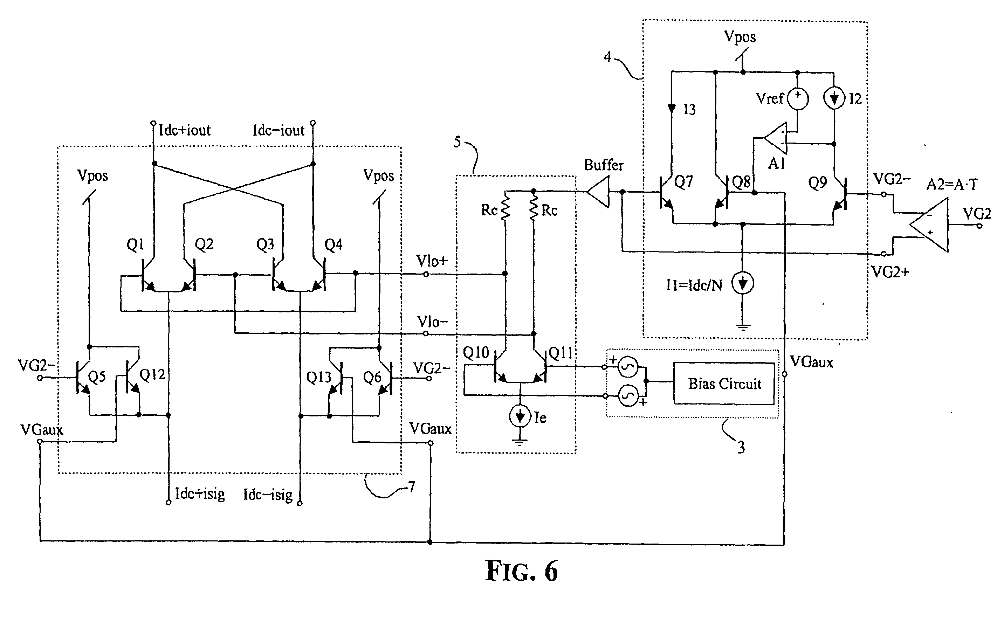

Such an auxiliary control circuit 4 is included in the circuit of the mixer of the invention depicted in Figure 6.

The mixer 7 is a modified embodiment of the VGM of Figure 1, from which it differs because of the presence of a pair of identical auxiliary transistors Q12 and Q13 acting as current diverters and of the transistors Q5 and Q6. The bases of transistors Q5 and Q6 are coupled to the control voltage $VG2^-$, which is one of the two differential outputs of the amplifier A2. The bases of transistors Q12 and Q13 are, on the contrary, coupled to the auxiliary voltage VGaux output of the amplifier A1 of the circuit 4. The base of the transistor Q7 of circuit 4 is coupled to the other output $VG2^+$ of the amplifier A2, and to the resistors $R_c$ of the amplifier 5, preferably by interposing a buffer stage BUFFER. Such a buffer provides the current $I_e$ that circulates in the differential amplifier 5 without loading the amplifier A2.

The external gain variation command VG2 is converted by the amplifier A2 in the differential signal $VG2^+$, $VG2^-$. The voltage $VG2^-$ is input to both the auxiliary control circuit 4 and the mixer 7. The voltage $VG2^+$ is input to the circuit 4 and, through the buffer BUFFER, to the differential amplifier 5.

In order to attenuate the output current signal $i_{out}$ of circuit 7 according to an exponential law with a high precision, the current $i_{out}$ must vary as the current I3 of the auxiliary control circuit 4. This occurs when the following equations are verified:

$$\frac{Idc}{I1} = \frac{A_e(Q1)}{A_e(Q7)} = \frac{A_e(Q12)}{A_e(Q8)} = \frac{A_e(Q5)}{A_e(Q9)} = N \qquad (4)$$

$$Q1 = Q2 = Q3 = Q4 \qquad (5)$$

Equation (4) states that the transistors of the mixer 7 must be a N: 1 scaled replica of the transistors of the auxiliary control circuit 4. Using the above described architecture, the signal $i_{sig}$ of the mixer 7 cannot interfere with the auxiliary control circuit 4, compromising its stability that occurs when the current of the transistor Q8 is very small. In these conditions, the response characteristic of the circuit 4 becomes rather slow and, should a signal $i_{sig}$ be present, it would undergo to a remarkable distortion.

It must be observed that the gain of mixers of the invention of Figures 3, 4 and 6 are temperature dependent, because in the equations (1) and (3) there appears the thermal voltage $V_T = k \cdot T/q$, wherein $T$ is the absolute temperature and $q$ is the electron charge. By consequence, the gain of the mixer depends from the control voltage and from the temperature.

The problem of temperature dependency is overcome by realizing the amplifier A2 of the mixers of the invention of Figures 3, 4 and 6 such that its gain varies proportionally with temperature:

$$A2 = A2(T) = A \cdot T \qquad (6)$$

Substituting equation (4) in equation (3):

$$I3 = K \cdot I2 \cdot e^{\frac{VG2^+ - VG2^-}{V_T}} = K \cdot I2 \cdot e^{\frac{A \cdot T \cdot VG2}{\frac{k \cdot T}{q}}} = K \cdot I2 \cdot e^{\frac{A \cdot q \cdot VG2}{k}} \qquad (7)$$

## EP 1 337 035 B1

In conclusion, the modulator proposed in Figure 6 has the following advantages:

- the gain of mixer 7 varies exponentially and independently from temperature;
- the auxiliary control circuit 4 is isolated from the signal $i_{sig}$ to be amplified;
- there is a good isolation between the input signal $i_{sig}$ and the output signal $i_{out}$ of the mixer 7 because they have different frequencies, thus it is possible to provide for relatively large gain variations;
- the coupling between the auxiliary control circuit 4 and the mixer 7 is implemented with little complexity by merely interposing a buffer and the differential amplifier 5;
- no external component is required.

## Claims

1. An exponentially variable gain mixer comprising
   a variable gain mixer (VGM) input with a differential signal to be amplified and frequency converted ($I_{dc}+i_{sig}$, $I_{dc}-i_{sig}$) and outputting an amplified and frequency converted differential signal ($I_{dc}+i_{out}$, $I_{dc}-i_{out}$) in function of a differential local oscillator signal ($Vlo^-$, $Vlo^+$) and of a gain control voltage (VG),
   at least an oscillating circuit (3) generating an oscillating differential signal,
   a correction circuit input with an external gain variation command (VG2) and with said oscillating differential signal, producing said differential local oscillator signal ($Vlo^-$, $Vlo^+$) and said gain control voltage (VG),
   **characterized in that**
   said correction circuit comprises a first amplifier (A2) input with said external gain variation command (VG2) and generating said gain control voltage ($VG2^-$) and a bias voltage ($VG2^+$) as a differential output signal, and
   a differential amplifier (5), having said bias voltage ($VG2^+$) as a reference; input with said oscillating differential signal and outputting said local oscillator differential signal ($Vlo^-$, $Vlo^+$).

2. The exponentially variable gain mixer of claim 1, wherein the gain of said first amplifier (A2) varies proportionally with temperature.

3. The exponentially variable gain mixer according to claim 1, further comprising a pre-distortion circuit (PRE-DISTORTION_CIRCUIT) input with the output voltages generated by said first amplifier (A2) and producing said gain control voltage (VG) and another bias voltage, said differential amplifier (5) having said other bias voltage, as a reference.

4. The exponentially variable gain mixer of claim 3, wherein said variable gain mixer (7) comprises a Gilbert cell having a pair of identical first (Q1, Q2) and second (Q3, Q4) differential stages biased with a certain current ($I_{dc}$) and having first (Q5) and second (Q6) respective identical regulation transistors of the current, controlled by said gain control voltage ($VG2^-$), and respective first (Q12) and second (Q13) identical auxiliary transistors in parallel to the respective regulation transistors (Q5, Q6) and controlled by an auxiliary voltage (VGaux),
   said pre-distortion circuit comprises an auxiliary control circuit (4) composed of
   a pair of first (Q9) and second (Q7) input transistors having a current node in common and in series to a current generator (I1), controlled respectively by said gain control voltage ($VG2^-$) and by said bias voltage ($VG2^+$), a second current generator (I2) connected between the second current node of said first input transistor (Q9) and a supply node,
   an operational amplifier (A1) having an input coupled to a reference voltage (Vpos-Vref) and the other input connected to said second current generator (I2), generating said auxiliary voltage (VGaux),
   a third transistor (Q8) controlled by said auxiliary voltage (VGaux) being connected in parallel to said second input transistor (Q7);
   the ratio (N) between the bias current ($I_{dc}$) of said Gilbert cell and the current produced by said current generator (I1) is equal to the ratio between the emitter areas of a transistor of the first differential stage (Q1, Q2) and of said second input transistor (Q7), of said first auxiliary transistor (Q12) and of said third transistor (Q8), and of said first regulation transistor (Q5) and of said first input transistor (Q9).

5. The exponentially variable gain mixer according to claim 4, wherein said differential amplifier (5) is coupled to said auxiliary control circuit (4) by a buffer stage (BUFFER) input with said bias voltage ($VG2^+$).

5

**Patentansprüche**

1. Mischer mit exponentiell veränderlicher Verstärkung, mit

   einem Mischer (VGM) mit veränderlicher Verstärkung, in den ein differentielles Signal ($I_{dc}$ + $i_{sig}$, $I_{dc}$ - $i_{sig}$), das verstärkt und dessen Frequenz umgesetzt werden soll, eingegeben wird, und der ein verstärktes und frequenzumgesetztes differentielles Signal ($I_{dc}$ + $i_{out}$, $I_{dc}$ - $i_{out}$) als Funktion eines differentiellen Hilfsoszillatorsignals (Vlo⁻, Vlo⁺) und einer Verstärkungssteuerspannung (VG) ausgibt,

   wenigstens einer Oszillationsschaltung (3), die ein oszillierendes differentielles Signal erzeugt,

   einer Korrekturschaltung, in die ein externer Verstärkungsveränderungsbefehl (VG2) und das oszillierende differentielle Signal eingegeben werden und die das differentielle Hilfsoszillatorsignal (Vlo⁻, Vlo⁺) und die Verstärkungssteuerspannung (VG) erzeugt,

   **dadurch gekennzeichnet, dass**

   die Korrekturschaltung einen ersten Verstärker (A2), in den der externe Verstärkungsveränderungsbefehl (VG2) eingegeben wird und der die Verstärkungssteuerspannung (VG2⁻) und eine Vorspannung (VG2⁺) als ein differentielles Ausgangssignal erzeugt, umfasst, und

   ein Differenzverstärker (5) vorgesehen ist, der die Vorspannung (VG2⁺) als eine Referenz besitzt, in den das oszillierende differentielle Signal eingegeben wird und der das differentielle Hilfsoszillatorsignal (Vlo⁻, Vlo⁺) ausgibt.

2. Mischer mit exponentiell veränderlicher Verstärkung nach Anspruch 1, bei dem sich die Verstärkung des ersten Verstärkers (A2) proportional zur Temperatur ändert.

3. Mischer mit exponentiell veränderlicher Verstärkung nach Anspruch 1, der ferner eine Vorverzerrungsschaltung (PRE-DISTORTION_CIRCUIT) umfasst, in die die Ausgangsspannungen, die von dem ersten Verstärker (A2) erzeugt werden, eingegeben werden und die die Verstärkungssteuerspannung (VG) und eine weitere Vorspannung erzeugt, wobei der differentielle Verstärker (5) die andere Vorspannung als eine Referenz hat.

4. Mischer mit exponentiell veränderlicher Verstärkung nach Anspruch 3, bei dem

   der Mischer (7) mit veränderlicher Verstärkung eine Gilbert-Zelle aufweist, die ein Paar aus einer ersten (Q1, Q2) und einer zweiten (Q3, Q4) differentiellen Stufe besitzt, die völlig gleich sind, mit einem bestimmten Strom ($I_{dc}$) vorgespannt werden und einen ersten (Q5) bzw. einen zweiten (Q6) Stromeinstelltransistor, die völlig gleich sind und durch die Verstärkungssteuerspannung (VG2) gesteuert werden, und einen ersten (Q12) bzw. einen zweiten (Q13) Hilfstransistor, die völlig gleich sind, zu den jeweiligen Einstelltransistoren (Q5, Q6) parallelgeschaltet sind und durch eine Hilfsspannung (VGaux) gesteuert werden, umfassen,

   die Vorverzerrungsschaltung eine Hilfssteuerschaltung (4) umfasst, die aufgebaut ist aus

   einem Paar aus einem ersten (Q9) und einem zweiten (Q7) Eingangstransistor, die einen gemeinsamen Stromknoten besitzen, mit einem Stromgenerator (I1) in Reihe geschaltet sind und durch die Verstärkungssteuerspannung (VG2⁻) bzw. durch die Vorspannung (VG2⁺) gesteuert werden, wobei ein zweiter Stromgenerator (I2) zwischen den zweiten Stromknoten des ersten Eingangstransistors (Q9) und einen Versorgungsknoten geschaltet ist,

   einem Operationsverstärker (A1), wovon ein Eingang mit einer Referenzspannung (Vpos - Vref) gekoppelt ist und der andere Eingang mit dem zweiten Stromgenerator (I2) verbunden ist und der die Hilfsspannung (VGaux) erzeugt, und

   einem dritten Transistor (Q8), der durch die Hilfsspannung (VGaux) gesteuert wird und zu dem zweiten Eingangstransistor (Q7) parallelgeschaltet ist; und

   das Verhältnis (N) zwischen dem Vorstrom ($I_{dc}$) der Gilbert-Zelle und dem durch den Stromgenerator (I1) erzeugten Strom gleich dem Verhältnis zwischen den Emitterflächen eines Transistors der ersten differentiellen Stufe (Q1, Q2) und des zweiten Eingangstransistors (Q7) des ersten Hilfstransistors (Q12) und des dritten Transistors (Q8) und des ersten Einstelltransistors (Q5) und des ersten Eingangstransistors (Q9) ist.

5. Mischer mit exponentiell veränderlicher Verstärkung nach Anspruch 4, bei dem der Differenzverstärker (5) mit der Hilfssteuerschaltung (4) über eine Pufferstufe (Buffer), in die die Vorspannung (VG2⁺) eingegeben wird, gekoppelt ist.

**Revendications**

1. Mélangeur à gain exponentiellement variable comprenant :

un mélangeur à gain variable (VGM) recevant un signal différentiel à amplifier et converti en fréquence ($I_{dc}+i_{sig}$, $I_{dc}-i_{sig}$) et fournissant un signal différentiel amplifié et converti en fréquence ($I_{dc}+i_{out}$, $I_{dc}-i_{out}$) en fonction d'un signal différentiel d'oscillateur local (Vlo⁻, Vlo⁺) et d'une tension de commande de gain (VG) ;

au moins un circuit oscillant (3) produisant un signal différentiel oscillant, un circuit de correction recevant une commande de variation de gain externe (VG2) et le signal différentiel oscillant, produisant le signal différentiel d'oscillateur local (Vlo⁻, Vlo⁺) et la tension de commande de gain (VG),

**caractérisé en ce que** :

le circuit de correction comprend un premier amplificateur (A2) recevant la commande de variation de gain externe (VG2) et produisant la tension de commande de gain (VG2⁻) et une tension de polarisation (VG2⁺) en tant que signal de sortie différentiel, et

un amplificateur différentiel (5) ayant ladite tension de polarisation (VG2⁺) comme référence, recevant le signal différentiel oscillant et fournissant le signal différentiel de l'oscillateur local (Vlo⁻, Vlo⁺).

**2.** Mélangeur à gain exponentiellement variable selon la revendication 1, dans lequel le gain du premier amplificateur (A2) varie proportionnellement à la température.

**3.** Mélangeur à gain exponentiellement variable selon la revendication 1, comprenant en outre un circuit de prédistorsion (PRE-DISTORTION CIRCUIT) recevant les tensions de sortie produites par le premier amplificateur (A2) et produisant la tension de commande de gain (VG) et une autre tension de polarisation, l'amplificateur différentiel (5) ayant ladite autre tension de polarisation comme référence.

**4.** Mélangeur à gain exponentiellement variable selon la revendication 3, dans lequel le mélangeur à gain variable (7) comprend une cellule de Gilbert comportant une paire de premiers (Q1, Q2) et seconds (Q3, Q4) étages différentiels identiques polarisés par un certain courant ($I_{dc}$) et des premier (Q5) et second (Q6) transistors respectifs identiques de régulation du courant commandés par la tension de commande de gain (VG2⁻), et des premier (Q12) et second (Q13) transistors auxiliaires identiques en parallèle sur les transistors de régulation respectifs (Q5, Q6) et commandés par une tension auxiliaire (VGaux),

le circuit de prédistorsion comprend un circuit de commande auxiliaire (4) constitué de :

une paire de premier (Q9) et second (Q7) transistors d'entrée ayant un noeud de courant en commun et en série avec un générateur de courant (I1), commandé par la tension de commande de gain (VG2⁻) et par la tension de polarisation (VG2⁺), un second générateur de courant (12) connecté entre le second noeud de courant du premier transistor d'entrée (Q9) et un noeud d'alimentation,

un amplificateur opérationnel (A1) ayant une entrée couplée à une tension de référence (Vpos-Vref) et son autre entrée connectée au second générateur de courant (I2), produisant la tension auxiliaire (VGaux),

un troisième transistor (Q8) commandé par la tension auxiliaire (VGaux) étant connecté en parallèle sur le second transistor d'entrée (Q7) ;

le rapport (N) entre le courant de polarisation ($I_{dc}$) de la cellule de Gilbert et le courant produit par le générateur de courant (I1) est égal au rapport entre les surfaces d'émetteur d'un transistor du premier étage différentiel (Q1, Q2) et du second transistor d'entrée (Q7), du premier transistor auxiliaire (Q12) et du troisième transistor (Q8), et du premier transistor de régulation (Q5) et du premier transistor d'entrée (Q9).

**5.** Mélangeur à gain exponentiellement variable selon la revendication 4, dans lequel l'amplificateur différentiel (5) est couplé au circuit de commande auxiliaire (4) par un étage tampon (BUFFER) recevant la tension de polarisation (VG2⁺).

**FIG. 1**

**FIG. 2**

**FIG. 3**

**FIG. 4**

FIG. 5

**FIG. 6**

EP 1 337 035 B1